# EUROPEAN PATENT APPLICATION

(11) **EP 4 398 686 A1**
(43) Date of publication of application: **10.07.2024**
(21) Application number: 23187381.1
(22) Date of filing: 24.07.2023
(51) Int. Cl.: H05K 5/00, H01M 50/258, H01M 50/264

(54) **CONNECTION FIXING DEVICE AND POWER SUPPLY MODULE**

(30) Priority: 05.01.2023 CN 202320026304 U
(71) Applicant: Sungrow Power Supply Co., Ltd., Hefei, Anhui 230088 (CN)
(72) Inventor: ZHENG, Sigen, Hefei (CN); LI, Jun, Hefei (CN); HUANG, Shuqiang, Hefei (CN)
(74) Representative: Zacco Norway AS

(57) **Abstract**

A connection fixing device and a power supply module are disclosed. The connection fixing device is configured to fix a laminated structure, the laminated structure includes multiple cases arranged in sequence, the connection fixing device includes a connecting rod assembly and fasteners, the connecting rod assembly includes multiple connecting rods, the multiple connecting rods are configured to connect the cases and form two rows arranged side by side, the two rows are arranged on at least one side surface of the cases, the connecting rods of the two rows are staggered relative to each other, and different connecting rods of a same row are connected to different cases. The fasteners are arranged at both opposite ends of the connecting rods, and are fastened to the cases through the connecting rods.

## Description

### FIELD

The present application relates to the technical field of fixing devices, and in particular to a connection fixing device and a power supply module.

### BACKGROUND

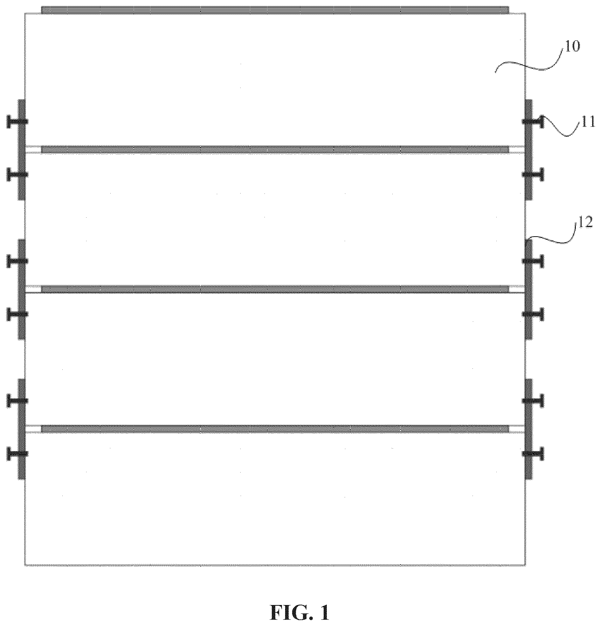

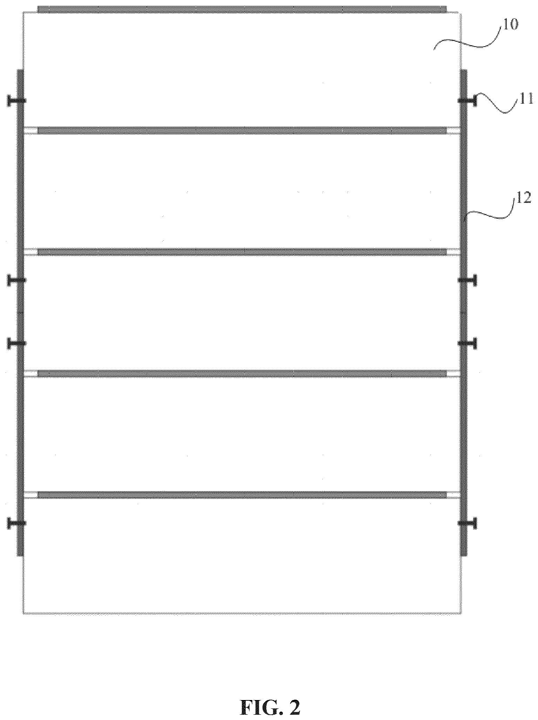

In practice, there are cases where multiple modules such as cases or cabinets are stacked or arranged in sequence, which not only fixes the structure of the modules to each other, but also improves the neatness of overall modules and avoid the phenomenon of multiple modules being placed in a disorderly manner. In the conventional technology, multiple modules are usually fastened together by means of connecting rods. Referring to FIG. 1, the connecting rods are short rods which connect two adjacent modules and are arranged in parallel on two opposite sides of the modules. Referring to FIG. 2, the connecting rods are long rods which connect two modules with a module being arranged therebetween and are arranged in parallel on two opposite sides of the modules. Two ends of the connecting rods are used for fixation through bolts. With the above connection manner, a large number of connecting members are required for connection, which results in too much installation steps and low efficiency of installation.

### SUMMARY

The main object of the present application is to provide a connection fixing device, which aims to improve the efficiency of the connection and fixation of a laminated structure.

In order to realize the above object, the connection fixing device according to the present application is configured for fixing a laminated structure. The laminated structure includes multiple cases arranged in sequence, and the connection fixing device includes:
a connecting rod assembly including multiple connecting rods, where the connecting rods are configured to connect the cases and form two rows arranged side by side, the two rows are arranged on at least one side of the cases, the connecting rods of the two rows are staggered relative to each other so that at least one of the cases connected by the connecting rods in a row is different from the cases connected by the connecting rods in the other row, and different connecting rods in the same row are connected to different ones of the cases.

In an embodiment, the connection fixing device further includes fasteners, which are arranged at both opposite ends of the connecting rods and fastened to the cases through the connecting rods.

In an embodiment, the two rows are arranged on two opposite sides of the cases, respectively.

In an embodiment, the two rows are arranged on two adjacent sides of the cases, respectively, and at least one of the two rows is arranged away from a joint of the two adjacent sides.

In an embodiment, the two rows are arranged on a same side surface of the cases, and the two rows are arranged at two opposite ends of the same side surface, respectively.

In an embodiment, the multiple connecting rods include a first rod and/or a second rod, the first rod is configured to connect two spaced cases, the second rod is configured to connect two adjacent cases, the two rows include a first row and a second row, where the connecting rods of the first row are connected in sequence in a direction of extension of the first row, and the connecting rods of the second row are connected in sequence in a direction of extension of the second row.

In an embodiment, the number of the cases is N1, if N1 is equal to or greater than 4 and a remainder ofNl divided by 3 is 1:
each of the multiple connecting rods is configured to be in type of the first rod, and the first rod of the first row and the first rod of the second row are staggered relative to each other.

In an embodiment, the number of the cases is N1, if N1 is equal to or greater than 4 and a remainder of N1 divided by 3 is 2:
the multiple connecting rods include multiple first rods and one second rod, the first rod of the first row and the first rod of the second row are staggered relative to each other, the second rod is arranged at an end of the first row, and the second rod and the first rod arranged at an end of the first row are arranged to be spaced relative to each other.

In an embodiment, the number of the cases is N1, if N1 is equal to or greater than 4 and N1 is a multiple of 3:
the multiple connecting rods include multiple first rods and one second rod, the first rod of the first row and the first rod of the second row are staggered relative to each other, the second rod is arranged at an end of the second row, and an end, closer to an end of the second row, of the second rod is flush with the first rod arranged at an end of the first row.

A power supply module is further provided according to the present application. The power supply module includes multiple power supply cases arranged in sequence and the foregoing connection fixing device, where the connection fixing device is configured to fix the multiple power supply cases.

In an embodiment, each of the power supply cases includes a housing and a power supply body arranged inside the housing, a mounting slot is provided on a side surface of the housing, and each of the connecting rods is at least partially fixed in the mounting slot.

In the technical solutions according to the present application, the connecting rod assembly is arranged on the multiple cases arranged in sequence, the connecting rod assembly includes multiple connecting rods, the multiple connecting rods is configured to connect two adjacent cases or two cases with a case being arranged therebetween and form two rows arranged side by side, and the two rows are arranged on at least one side of the cases. Since different connecting rods of the same row are connected to different ones of the cases, the number of fixing points on a case arranged at an end of the connecting rods is at most two. The number of fixing points on the cases in the technical solutions according to the present application is less than that in the conventional technology, thereby reducing the number of the connecting rods. The staggered arrangement of the connecting rods in the two rows allows that at least one of the cases connected by the connecting rods in a row is different from the cases connected by the connecting rods in the other row, so that cases as many as possible are fixed through fixing points as few as possible and it is ensured that the cases are fixed. This reduces the number of installation steps in fixation of multiple cases and increases the efficiency of installation. The fasteners are arranged at two opposite ends of the connecting rods, pass through the connecting rods and are fastened to the cases, thereby fixing the cases.

### BRIEF DESCRIPTION OF THE DRAWINGS

For more clearly illustrating the technical solutions in the embodiments of the present application or in the conventional technology, the accompanying drawings used in the description of the embodiments or the conventional technology will be briefly described hereinafter. Apparently, the accompanying drawings described hereafter illustrate only embodiments of the present application, and other drawings can be obtained by those skilled in the art based on the structures illustrated in the drawings without any creative efforts.
FIG. 1 shows a schematic structural diagram of a connection fixing device in the conventional technology;
FIG. 2 shows a schematic structural diagram of a connection fixing device in another conventional technology;
FIG. 3 shows a schematic structural diagram of a connection fixing device according to a first embodiment of the present application viewed from one perspective;
FIG. 4 shows a schematic structural diagram of the connection fixing device in FIG. 3 viewed from another perspective;
FIG. 5 shows a schematic structural diagram of a connection fixing device according to a second embodiment of the present application viewed from one perspective;
FIG. 6 shows a schematic structural diagram of the connection fixing device in FIG. 5 viewed from another perspective;
FIG. 7 shows a schematic structural diagram of a connection fixing device according to a third embodiment of the present application;
FIG. 8 shows a schematic structural diagram of a connection fixing device according to a fourth embodiment of the present application;
FIG. 9 shows a schematic structural diagram of a connection fixing device according to a fifth embodiment of the present application; and
FIG. 10 shows a schematic structural diagram of a connection fixing device according to a sixth embodiment of the present application.

Reference numerals are described as follows:

| Reference numeral | Name | Reference numeral | Name |
|---|---|---|---|
| 10 | module | 221 | first row |
| 11 | connecting rod | 222 | second row |
| 12 | bolt | 23 | fastener |
| 20 | connection fixing device | 30 | power supply module |
| 21 | connecting rod assembly | 31 | power supply case |
| 211 | first rod | 311 | housing |
| 212 | second rod | 312 | mounting slot |
| 22 | vertical row | | |

The object realization, functional features and advantages of the present application will be further described referring to the attached drawings and in conjunction with the embodiments.

### DETAILED DESCRIPTION OF THE EMBODIMENTS

The technical solutions according to the embodiments of the present application will be described clearly and completely as follows in conjunction with the drawings in the embodiments of the present application. It is apparent that the described embodiments are only a part of the embodiments according to the present application, rather than all of the embodiments. All other embodiments obtained by those skilled in the art without creative efforts based on the embodiments of the present application shall fall within the protection scope of the present application.

It should be noted that all directional indications (such as up, down, left, right, front, and back) in the embodiments of the present application are only used to explain the relative position relationship between components and movements of the components in a specific posture (as shown in the drawings). If the specific posture changes, the directional indications change accordingly.

In addition, in the present application, the terms, such as "first" and "second", are only used for descriptive purposes, and should not be understood as indicating or implying the relative importance or implicitly indicating the number of indicated technical features. Therefore, the features defined with "first", "second" or the like may include at least one of the features explicitly or implicitly. In addition, the term "and/or" throughout the specification include three solutions in parallel, for example, "A and/or B" includes A solution or B solution, or a solution where both A and B are satisfied. The technical solutions of the various embodiments can be combined with each other, but the combination should be based on the realization by those skilled in the art. When the combination of technical solutions is contradictory or cannot be realized, it should be considered that the combination of technical solutions does not exist, and is not within the protection scope of the present application.

In practice, there are cases where multiple modules 10 such as cases or cabinets are stacked or arranged in sequence, which not only fixes the structure of the modules 10 to each other, but also improves the neatness of overall modules 10 and avoid the phenomenon of multiple modules 10 being placed in a disorderly manner. For example, when multiple power supply cases are required to be connected in series so as to increase a power supply voltage and power, the power supply cases being fixed together not only facilitates circuit connection, but also makes the power supply cases neater and easier to be moved.

In the conventional technology, multiple connecting rods 11 are arranged side by side to form two rows and arranged in parallel on two opposite sides of the modules 10. The connecting rods in each row are connected end to end in the same module 10, in order to fix the multiple modules 10 together. The connecting rods 11 include long rods and short rods. Referring to FIG. 1 and FIG. 2, each connecting rod 11 in FIG. 1 is a short rod, so that each of the cases has four fixing points, to ensure that each of the modules 10 has a fixing point to be fixed. Each connecting rod 11 in FIG. 2 is a long rod, so that the cases at the ends of the long rods all have four fixing points and the modules 10 arranged along the middle portion of the long rods have no fixing points and can only be fixed by a clamping force between two adjacent modules 10, and each of the modules 10 has two fixing points on average. Therefore, the number of fixing points for each of the modules 10 is high and then more connecting rods 11 are used, resulting in too much installation steps and low efficiency of installation in fixation of multiple modules 10.

In view of this, a connection fixing device 20 is provided according to the present application. The connection fixing device 20 is configured for fixing a laminated structure, the laminated structure includes multiple cases arranged in sequence, and the connection fixing device 20 is configured to fix the multiple cases.

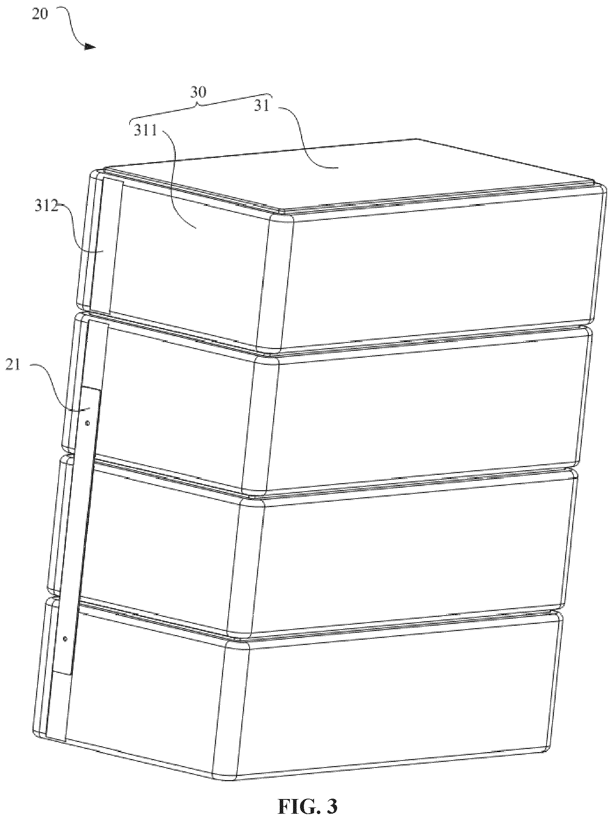

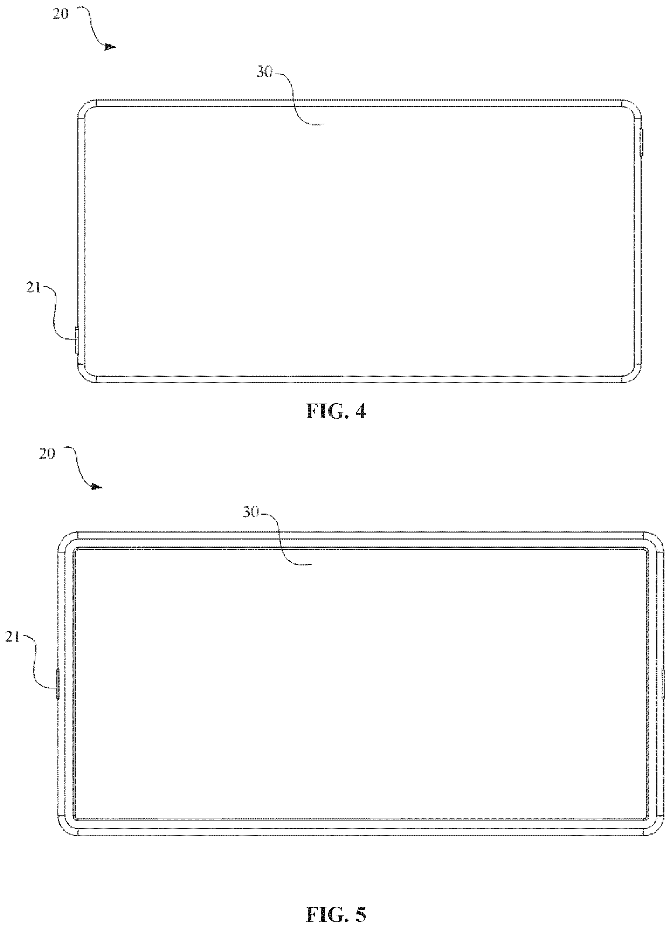

In an embodiment of the present application, as shown in FIG. 3 to FIG. 10, the connection fixing device 20 includes:
a connecting rod assembly 21, where the connecting rod assembly 21 includes multiple connecting rods, each of which is configured to connect two adjacent cases or two spaced cases, respectively. Herein, the term "two spaced cases" refers to that there is at least one additional case arranged between said two spaced cases. The multiple connecting rods form two vertical rows 22 arranged side by side. The two vertical rows 22 are arranged on at least one side of the cases, the connecting rods of the two vertical rows 22 are staggered relative to each other, and the connecting rods of the same vertical row 22 are connected with different cases;
a fastener 23, where the fastener 23 is arranged at two opposite ends of the connecting rod, and the fastener 23 is fastened to the cases through the connecting rods.

Specifically, since the connecting rods of the same vertical row 22 are connected to different cases, the number of fixing points on a case arranged at the end of the connecting rods is at most two while other cases have one fixing point per each or no fixing points. In that case, given the same length of the used connecting rods, the number of connecting rods and the number of fixing points in the present application are less than those in the conventional technology. The number of the fixing points is thus reduced, and the number of the connecting rods is reduced. Moreover, the connecting rods of the two vertical rows 22 are staggered relative to each other, so that at least one of the cases connected by the connecting rods in a row is not the same one connected by the connecting rods in the other row, so that, with as few fixing points as possible, as many cases as possible can be fixed, which can ensure the cases to be fixed. Each connecting rod of the same vertical row 22 is connected to different cases, so that two adjacent connecting rods of the same vertical row 22 are connected to two adjacent cases, respectively, or to two spaced cases, depending on the length or the number of the connecting rods. Accordingly, the number of the connecting rods is reduced and the possibility of overlapping of the connecting rods is reduced.

In the technical solutions according to the present application, the connecting rod assembly 21 is arranged on the multiple cases arranged in sequence, the connecting rod assembly 21 includes multiple connecting rods, which are configured to connect two adjacent cases or two spaced cases and form two vertical rows 22 arranged side by side. The two vertical rows 22 are arranged on at least one side of the cases. Since each connecting rod of the same vertical row 22 is connected to different cases, the number of fixing points on a case arranged at an end of the connecting rods is at most two. The number of fixing points on the cases in the technical solutions according to the present application is less than that in the conventional technology, and thus the number of the connecting rods is also reduced. The staggered arrangement of the connecting rods in the two vertical rows 22 allows that at least one of the cases connected by the connecting rods in a row is not the same one connected by the connecting rods in the other row, so that, with as few fixing points as possible, as many cases as possible can be fixed, which can ensure the cases to be fixed. Accordingly, the number of installation steps in fixation of multiple cases is reduced and the efficiency of installation is improved. Moreover, the fasteners 23 are arranged at two opposite ends of the connecting rods, are fastened to the cases through the connecting rods, thereby fixing the cases. Herein, it should be noted that the fastener is embodied as bolt in the application. However, the present application is not limited to that, and other kinds of fasteners and fixation manner are also applicable, such as welding, snap-fitting, and so on,

In an embodiment, referring to FIG. 3 to FIG. 9, the two vertical rows 22 are arranged on two opposite side surfaces of the cases. Specifically, since the connecting rods are all configured to fix the cases, if the connecting rods of the two vertical rows 22 are arranged too closed, it will bring disadvantage on applying uniform force on the cases and may cause the cases to be moved. Therefore, the two vertical rows 22 are arranged on two opposite side surfaces of the cases, respectively, and positions of the two vertical rows 22 are not limited, for example, the two vertical rows 22 may be arranged opposite to each other, or may be arranged diagonally with being staggered.

In a further embodiment, the two vertical rows 22 are arranged on two adjacent sides of the cases, respectively, and at least one of the two vertical rows 22 is arranged away from a joint of the two adjacent sides. Specifically, since the connecting rods are configured to fix the cases, if the connecting rods of the two vertical rows 22 are arranged too closed, it will bring disadvantage on applying uniform force on the cases and may cause the cases to be moved. Therefore, at least one of the two vertical rows 22 arranged at two adjacent sides of the cases is arranged away from the joint of the two adjacent sides. The joint of the two sides is an edge between the two vertical rows 22, and the two vertical rows 22 may be arranged away from the edge, so that the two vertical rows 22 are arranged approximately diagonally, or one of the two vertical rows 22 is arranged away from the edge.

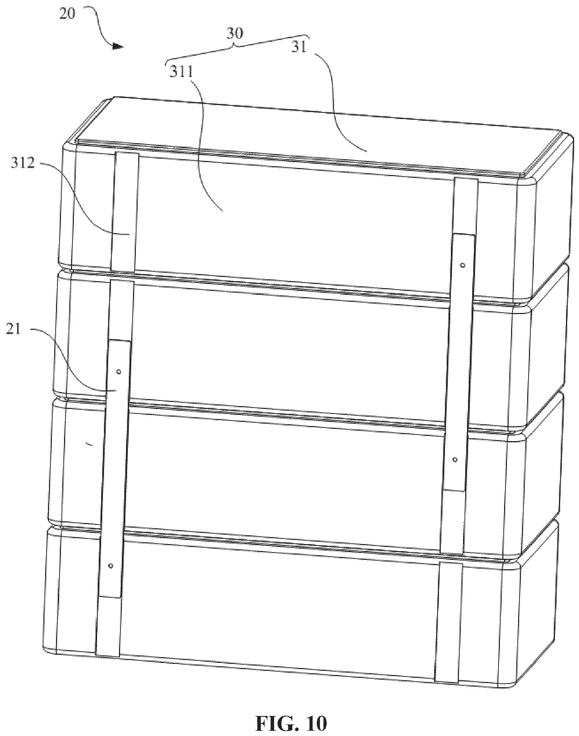

In another embodiment, referring to FIG. 10, the two vertical rows 22 are arranged on the same side surface of the cases, and the two vertical rows 22 are arranged on two opposite ends of the side surface, respectively. Specifically, since the connecting rods are configured to fix the cases, if the connecting rods of the two vertical rows 22 are arranged too closed, it will bring disadvantage on applying uniform force on the cases and may cause the cases to be moved..

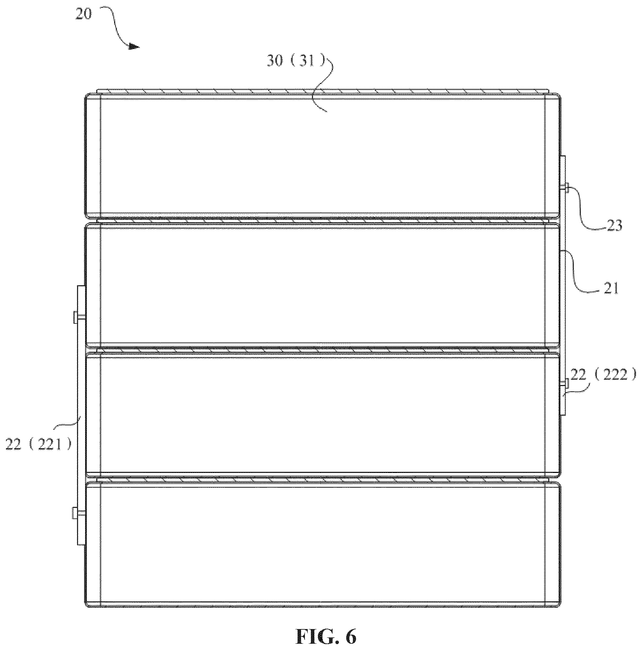

Referring to FIG. 6 to FIG. 9, the multiple connecting rods includes a first rod 211 and/or a second rod 212, where the first rod 211 is configured to connect two spaced cases, and the second rod 212 is configured to connect two adjacent cases. The two vertical rows 22 include a first vertical row 221 and a second vertical row 222. The connecting rods of the first vertical row 221 are connected in sequence along a direction of extension of the first vertical row 221, and the connecting rods of the second vertical row 222 are connected in sequence along a direction of extension of the second vertical row 222. Specifically, the first rod 211 is configured to connect two spaced cases, i.e. the first rod 211 can connect three cases. In this case, if the two first rods 211 are staggered, the two first rods 211 can only be connected to adjacent cases respectively, so that one side of the cases is fixed through fixing points and the other side is limited by the middle portion of the first rods 211. This ensures that each of the cases can have one fixing point. In addition, the second rod 212 is configured to connect two adjacent cases and is configured to reinforce the connection of the case, of which end is not able to be fixed, at the end of laminated structure, or to reinforce the connection of the first rod 211 on the opposite side, so that one side of the cases is fixed by fixing points and the other side is limited by the middle portion of the first rod 211 or by the fasteners 23. Compared to the conventional technology, referring to FIG. 2, the long rods of the two rows are arranged opposite to each other and the modules 10 arranged in the middle portion of the long rods is not provided with fixing points and can only be fixed by a clamping force between the two adjacent modules 10, and thus are vulnerable to falling, which does not facilitate the fixation of the laminated structure.

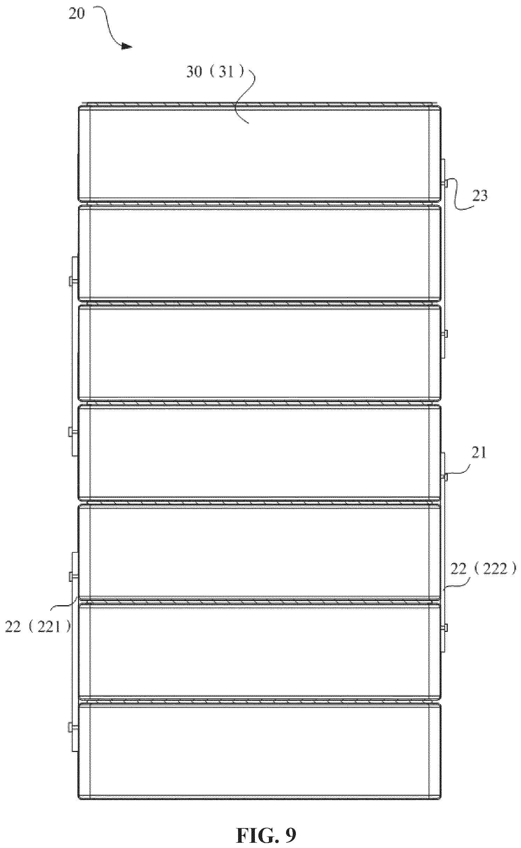

Further, the number of the cases is N1, if N1 is equal to or greater than 4 and a remainder of N1 divided by 3 is 1, each of the multiple connecting rods is configured to be in type of the first rod 211, where the first rod 211 of the first vertical row 221 and the first rod 211 of the second vertical row 222 are staggered relative to each other. Specifically, as shown in FIG. 6, the number of the cases is 4, and the multiple cases are arranged on one side from down to up, both ends of the first rod 211 of the first vertical row 221 are connected to a first case and a third case, respectively, and both ends of the first rod 211 of the second vertical row 222 are connected to a second case and a fourth case, respectively, so that the two first rods 211 are staggered, thereby ensuring that each case can have one fixing point and thus ensuring fixation of the cases. If the number of the cases N1 is greater than 4, the number of the first rod 211 is represented as n1, where it is satisfied that n1= 2 (N1-1) /3. Referring to FIG. 9, the number of the cases is 7, then the number of the first rod 211 is 4.

If the number of the cases is 2, one second rod 212 may be provided to be fixed or two second rods 212 may be provided on two sides of the cases, respectively. If the number of the cases is 3, only two second rods 212 may be provided which are staggered, or two first rods 211 may be provided which are fixed on two sides of the cases, respectively, or one first rod 211 or one second rod 212 may be provided.

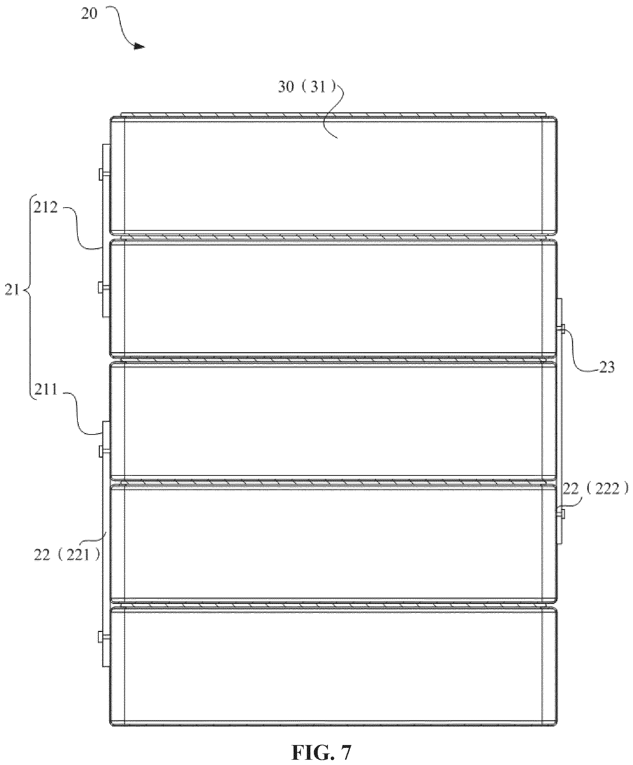

In another embodiment, the number of the cases is N1, and if N1 is equal to or greater than 4 and a remainder of N1 divided by 3 is 2, the multiple connecting rods include multiple first rods 211 and one second rod 212, where the first rod 211 of the first vertical row 221 and the first rod 211 of the second vertical row 222 are staggered relative to each other, the second rod 212 is arranged at one end of the first vertical row 221, and the second rod 212 and the first rod 211 arranged at the end of the first vertical row 221 are arranged to be spaced relative to each other. Specifically, referring to FIG. 7, in a case that the laminated structure has five cases, for example, from bottom to top, both ends of the first rod 211 of the first vertical row 221 are connected to a first case and a third case, respectively, and both ends of the first rod 211 of the second vertical row 222 are connected to a second case and a fourth case, respectively, so that the first rods 211 of the two vertical rows 22 are staggered, and the second rod 212 and the first rod 211 arranged at the end of the first vertical row 221 are staggered. The uppermost case cannot be fixed, and is therefore fixed through the second rod 212. If the number of the cases N1 is greater than 4, the number of the first rods 211 is represented as n1, and the number of the second rod 212 is represented as n2, it is satisfied that n1=2 (N1-2) /3, and n2=1.

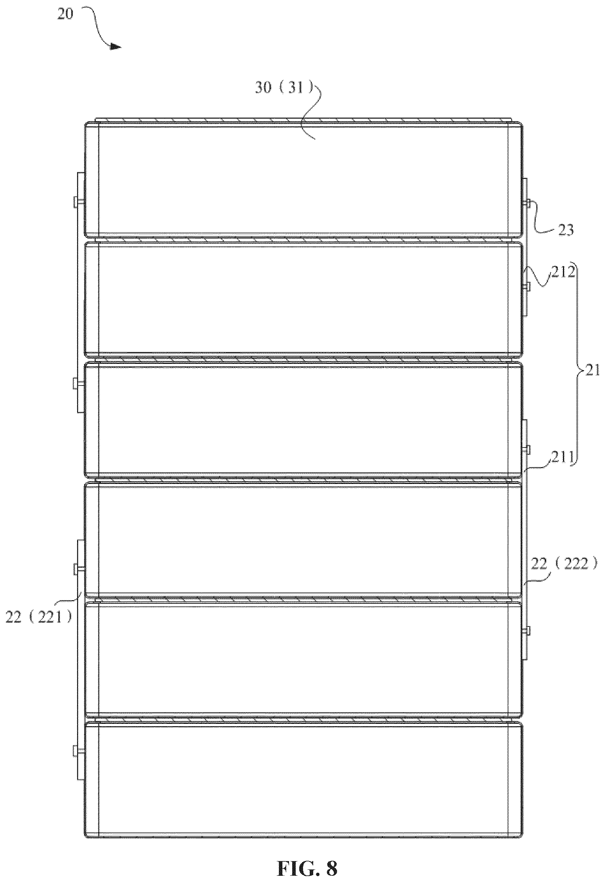

In another embodiment, the number of the cases is N1, if N1 is equal to or greater than 4 and N1 is a multiple of 3, the multiple connecting rods include multiple first rods 211 and one second rod 212, the first rod 211 of the first vertical row 221 and the first rod 211 of the second vertical row 222 are staggered relative to each other, the second rod 212 is arranged at one end of the second vertical row 222, and the end, closer to an end of the second vertical row 222, of the second rod 212 is flush with the first rod 211 arranged at the end of the first vertical row 221. Referring to FIG. 8, in a case that the laminated structure has six cases, for example, from bottom to top, both ends of the first of the first rod 211 of the first vertical row 221 are connected to a first case and a third case, respectively, both ends of a second first rod 211 are connected to a fourth case and a sixth case, respectively, and both ends of the first rod 211 of the second vertical row 222 are connected to a second case and the fourth case, respectively, so that the first rod 211 of the two vertical rows 22 are staggered. The second case to last cannot be fixed, and is therefore fixed through the second rod 212. An end, closer to an end of the second vertical row 222, of the second rod 212 is flush with the first rod 211 arranged at the end of the first vertical row 221. If the number of the cases N1 is greater than 4, the number of the first rod 211 is represented as n1 and the number of the second rod 212 is represented as n2, it is satisfied that n1= (2N1-3) /3 and n2=1.

A power supply module 30 is provided according to the present application. The power supply module 30 includes multiple power supply cases 31 arranged in sequence and a connection fixing device 20, the specific structure of the connection fixing device 20 is referred to the above embodiments. The power supply module 30 adopts all the technical solutions of the above embodiments, and thus has at least all the advantageous effects of the technical solutions of the above embodiments, which are not repeated in detail here. The connection fixing device 20 is configured to fix the multiple power supply cases 31.

In an embodiment, each of the power supply cases 31 includes a housing 311 and a power supply body arranged inside the housing 311. A mounting slot 312 is provided on a side of the housing 311, and each of the connecting rods is at least partially fixed in the mounting slot 312. Specifically, the mounting slot 312 is provided on a side of the housing 311, and each of the connecting rods is at least partially fixed in the mounting slot 312. That is, the thickness of the connecting rods is greater than or equal to the depth of the mounting slot 312, which not only limits the connecting rods, facilitates the installation of the connecting rods, reduces the possibility of displacement of the connecting rods and ensures the stability of installation of the connecting rods, but also enables the connecting rods to further limit a power cable, and reducing the possibility of displacement of the power supply cases 31.

The above embodiments are only preferred embodiments of the present application, and do not limit the scope of the present application. With the inventive concept of the present application, any equivalent structural transformation made by using the contents of description and drawings of the present application, or direct/indirect implementation in other related technical fields, are included in the protection scope of the present application.

## Claims

1. A connection fixing device configured for fixing a laminated structure, the laminated structure comprising a plurality of cases arranged in sequence, wherein the connection fixing device comprises:
a connecting rod assembly comprising a plurality of connecting rods, wherein the connecting rods are configured to connect the cases and form two rows arranged side by side, the two rows are arranged on at least one side of the cases, the connecting rods of the two rows are staggered relative to each other, so that at least one of the cases connected by the connecting rods in a row is different from the cases connected by the connecting rods in the other row, and different connecting rods in the same row are connected to different case.

2. The connection fixing device according to claim 1, wherein the two rows are arranged on two opposite side surfaces of the cases, respectively.

3. The connection fixing device according to claim 1, wherein the two rows are arranged on two adjacent sides of the cases, respectively, and at least one of the two rows is arranged away from a joint of the two adjacent sides.

4. The connection fixing device according to claim 1, wherein the two rows are arranged on the same side surface of the cases, and the two rows are arranged at two opposite ends of the same side surface, respectively.

5. The connection fixing device according to any one of claims 1 to 4, wherein the plurality of connecting rods comprise a first rod and/or a second rod, the first rod is configured to connect two spaced cases, the second rod is configured to connect two adjacent cases, the two rows comprise a first row and a second row, wherein the connecting rods of the first row are connected in sequence in a direction of extension of the first row, and the connecting rods of the second row are connected in sequence in a direction of extension of the second row.

6. The connection fixing device according to claim 5, wherein the number of the cases is N1, if N1 is equal to or greater than 4 and a remainder of N1 divided by 3 is 1:
each of the plurality of connecting rods is configured to be in type of the first rod, and the first rod of the first row and the first rod of the second row are staggered relative to each other.

7. The connection fixing device according to claim 5, wherein the number of the cases is N1, if N1 is equal to or greater than 4 and a remainder of N1 divided by 3 is 2:
The plurality of connecting rods comprise a plurality of first rods and one second rod, the first rod of the first row and the first rod of the second row are staggered relative to each other, the second rod is arranged at an end of the first row, and the second rod and the first rod arranged at an end of the first row are arranged to be spaced relative to each other.

8. The connection fixing device according to claim 5, wherein the number of the cases is N1, if N1 is equal to or greater than 4 and N1 is a multiple of 3:
the plurality of connecting rods comprise a plurality of first rods and one second rod, the first rod of the first row and the first rod of the second row are staggered relative to each other, the second rod is arranged at an end of the second row, and an end, closer to an end of the second row, of the second rod is flush with the first rod arranged at an end of the first row.

9. The connection fixing device according to claim 1, further comprising fasteners, wherein the fasteners are arranged at both opposite ends of the connecting rod and fastened to the cases through the connecting rods

10. A power supply module, comprising a plurality of power supply cases arranged in sequence and the connection fixing device according to any one of claims 1 to 9, wherein the connection fixing device is configured to fix the plurality of power supply cases.

11. The power supply module according to claim 10, wherein each of the power supply cases comprises a housing and a power supply body arranged inside the housing, a mounting slot is provided on a side surface of the housing, and each of the connecting rods is at least partially fixed in the mounting slot.
